# EUROPEAN PATENT APPLICATION

(11) **EP 2 924 982 A2**
(43) Date of publication of application: **30.09.2015**
(21) Application number: 15161304.9
(22) Date of filing: 27.03.2015
(51) Int. Cl.: H04N 5/64, G09F 15/00, G06Q 30/02, G09F 23/00

(54) **PANEL FOR DISPLAY SCREENS**

(30) Priority: 28.03.2014 IT MI20140536
(71) Applicant: Raccah, Simon Jacques, 20090 Segrate (MI) (IT)
(72) Inventor: Raccah, Simon Jacques, 20090 Segrate (MI) (IT)
(74) Representative: Modiano, Micaela Nadia

(57) **Abstract**

A panel (10) for display screens (5), the particularity of which resides in that it comprises a first L-shaped element (1) and a second L-shaped element (2) and a first angular element and a second angular element, the first and second angular elements (3, 4) being adapted to be coupled internally to the first and second L-shaped elements (1, 2), so as to define telescopically extensible opposite sides of a quadrangular frame adapted to be arranged around a display screen (5).

## Description

The present invention relates to a panel for display screens. More particularly, the invention relates to a panel for display screens such as TV screens, monitor screens, laptop screens, netbook screens, PC screens and the like and other objects having a parallelepiped structure.

As is known, display screens are currently one of the most used means and people spend a large number of hours in front of them.

These screens might constitute an important advertising and communication medium that goes beyond what can be displayed on the screen proper, although the screens might be used as advertising media themselves or, as an alternative, as media for presenting information indeed in addition to what is displayed on the screen proper.

Currently there are no available solutions that allow to transform the display screen into an advertising or informational medium regardless of whether the screen is on and therefore of whether content can be displayed on it or not.

The aim of the present invention is to provide a panel for display screens that allows to extend the possibilities of said screen, allowing to display in a permanent manner advertising and/or informational content.

Within this aim, an object of the present invention is to provide a panel for display screens that can be retrofitted to screens of the existing type.

Another object of the present invention is to provide a panel for display screens the installation of which is extremely simple, as is its removal.

Another object of the present invention is to provide a panel for display screens that is highly reliable, relatively easy to provide and at competitive costs.

This aim and these and other objects that will become better apparent hereinafter are achieved by a panel for display screens, characterized in that it comprises a first L-shaped element and a second L-shaped element and a first angular element and a second angular element, said first and second angular elements being adapted to be coupled inside said first and second L-shaped elements, so as to define telescopically extensible opposite sides of a quadrangular frame adapted to be arranged around a display screen.

Further characteristics and advantages of the invention will become better apparent from the description of a preferred but not exclusive embodiment of the panel according to the present invention, illustrated by way of non-limiting example in the accompanying drawings, wherein:

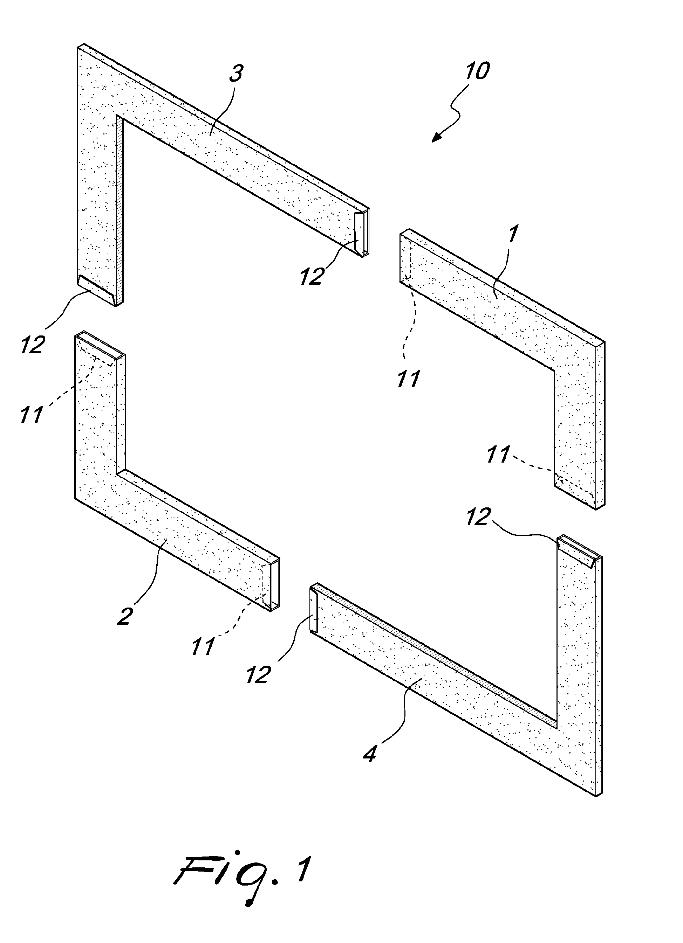

Figure 1 is an exploded perspective view of the panel according to the present invention;

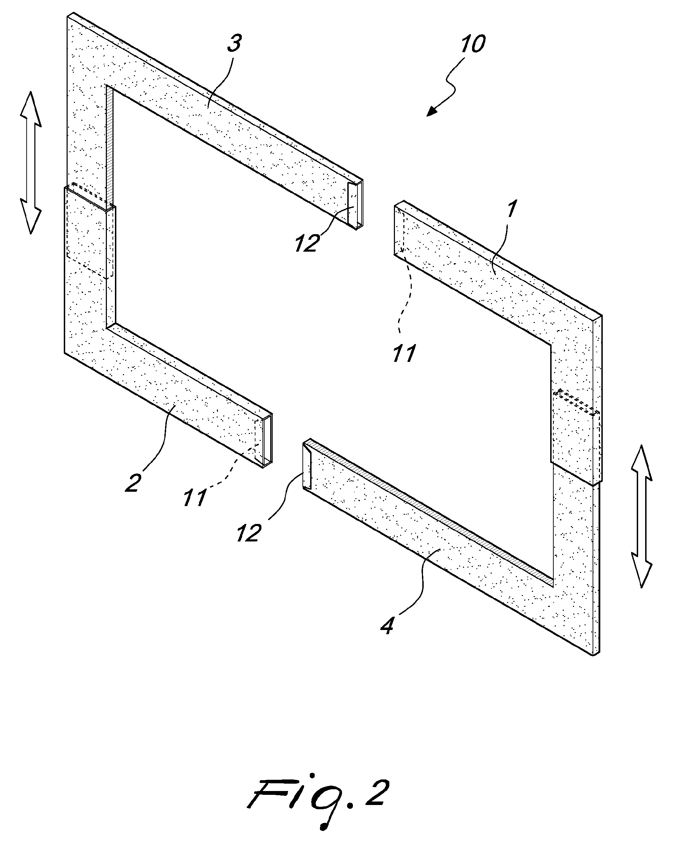

Figure 2 is a perspective view of a first step of assembly of the panel according to the present invention;

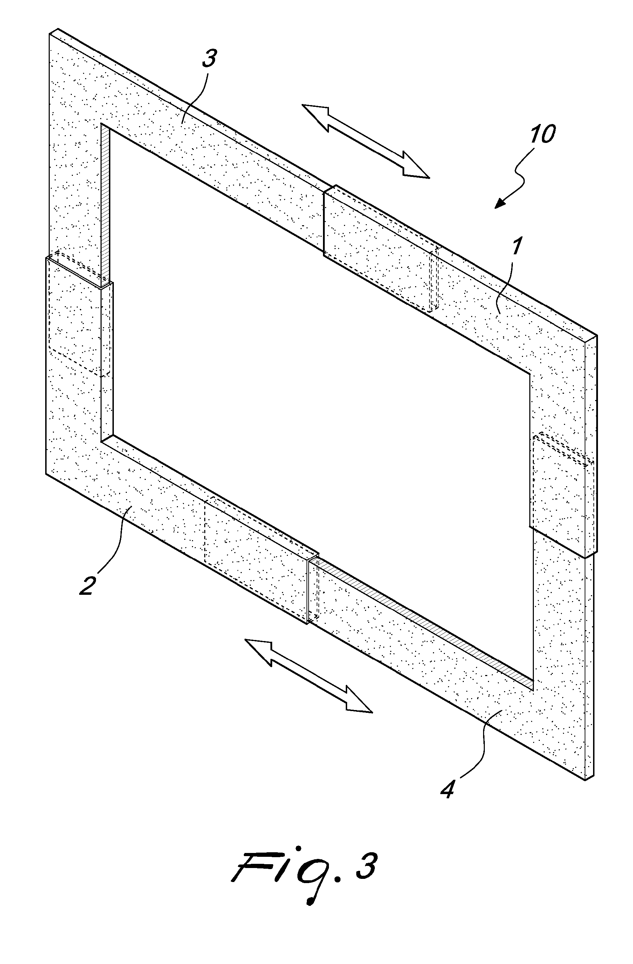

Figure 3 is a perspective view of a second step of assembly of the panel according to the invention;

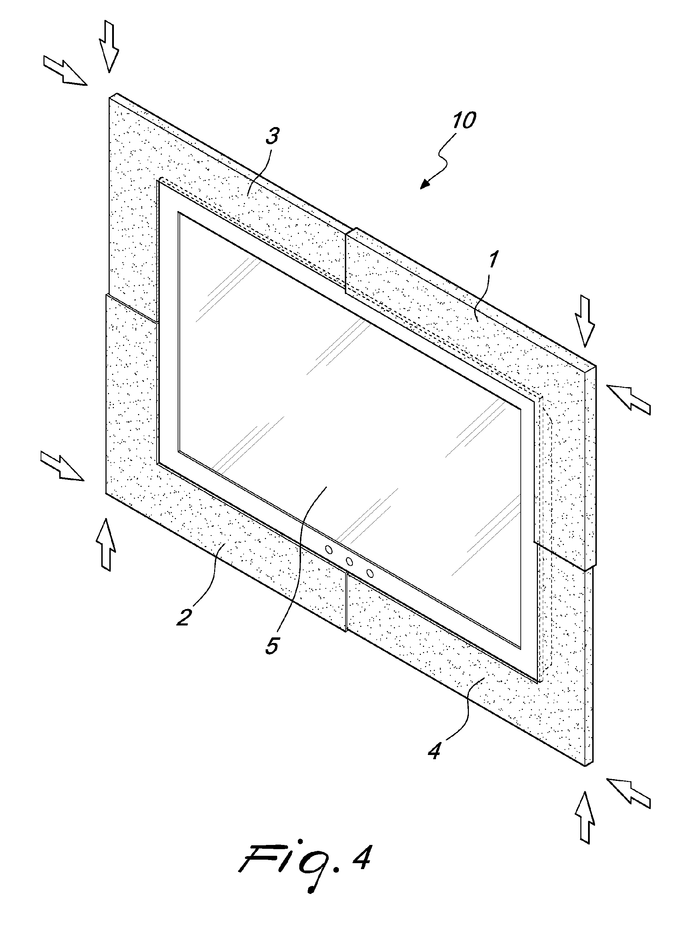

Figure 4 is a perspective view of the panel according to the invention arranged around a display screen;

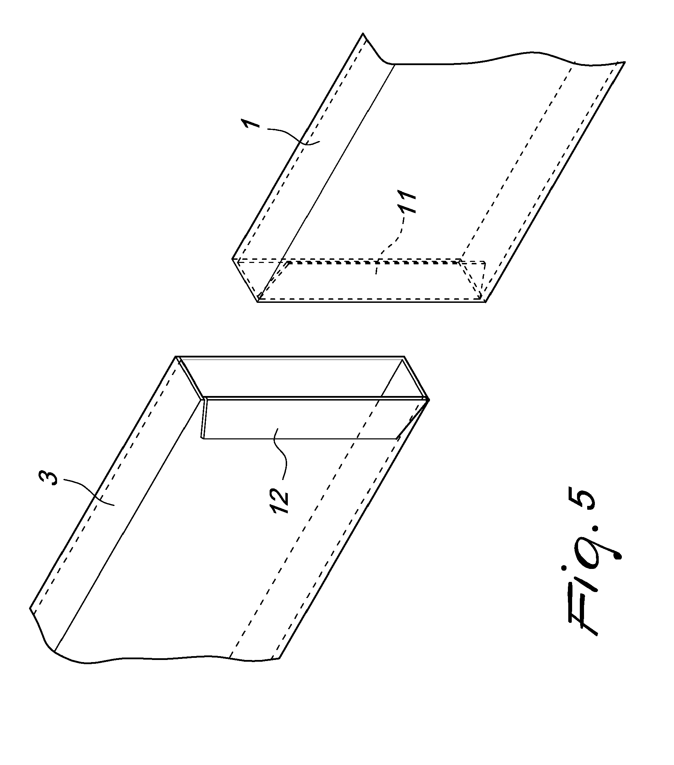

Figure 5 is a perspective view of a detail of the panel according to the present invention;
Figure 6 is an exploded front perspective view of a second embodiment of the panel according to the invention;
Figure 7 is an exploded rear perspective view of the panel of Figure 6;
Figure 8 is a front perspective view of a second embodiment of the panel according to the invention, with the panel in the active configuration;
Figure 8a is a front perspective view of the panel of Figure 8 in the extended configuration;
Figure 9 is a rear perspective view of the panel of Figure 8;
Figure 9a is a front perspective view of the panel of Figure 8a.

With reference to the figures, the panel according to the present invention, generally designated by the reference numeral 10, comprises a first L-shaped element 1 and a second L-shaped element 2 and a first angular element 3 and a second angular element 4, which also are L-shaped and are adapted to couple to the L-shaped elements 1 and 2.

Substantially, each angular element 3 and 4 couples inside an end of the first and second L-shaped elements, in order to define telescopically extensible opposite sides of a quadrangular structure, which is adapted to be arranged around a display screen 5 like a frame.

The presence of the angular elements 3 and 4 allows to adapt in length and height the quadrangular structure or frame thus provided, so as to be able to arrange it around the display screen 5 and therefore be able to adapt it perfectly to the measurements of said screen.

Substantially, the quadrangular structure is provided with the angular elements 3 and 4, which couple inside the respective L-shaped elements 1 and 2, so as to define the corners of the quadrangular structure, the elements 1 and 2 defining the sides of said structure.

The frame thus provided is extensible in two dimensions, i.e., in width and in height, so as to be able to adapt, as mentioned, to the perimeter of a display screen.

The frame thus provided can be used for advertising messages, informational messages, etc.

Therefore, the panel according to the invention, which defines a frame for a display screen, becomes an advertising or informational medium which combines with the display screen, integrating the contents thereof or adding content to it.

In order to prevent the telescopically extensible opposite sides from escaping from their own guides, there is, inserted inside the first and second angular elements, in both ends, at least one tab 11 that is folded outwardly.

In the L-shaped elements there is also at least one tab 12 that is folded inwardly, and once the angular element has been mated with the L-shaped element, one prevents the two elements from sliding off each other by means of the engagement between the two tabs 11 and 12.

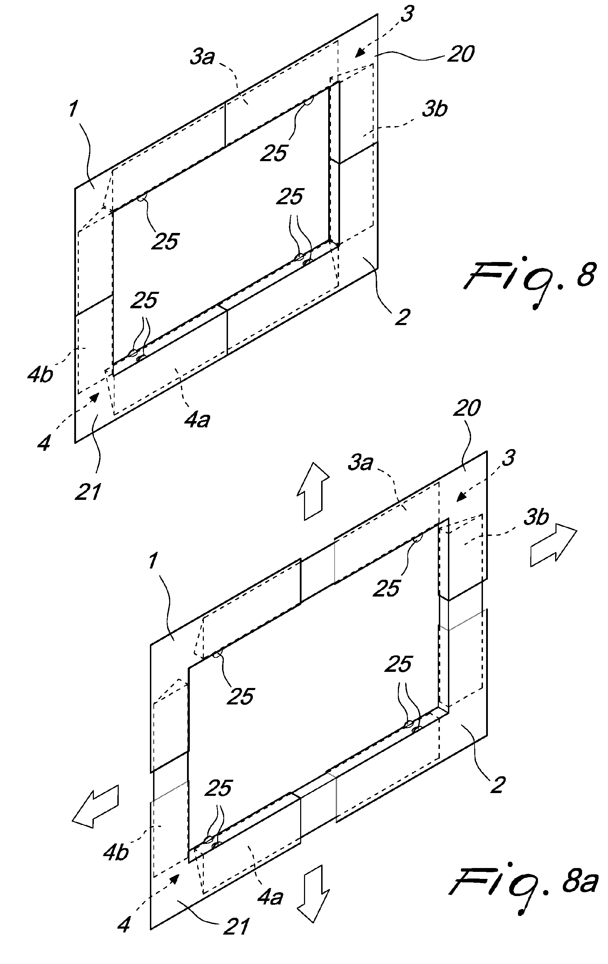

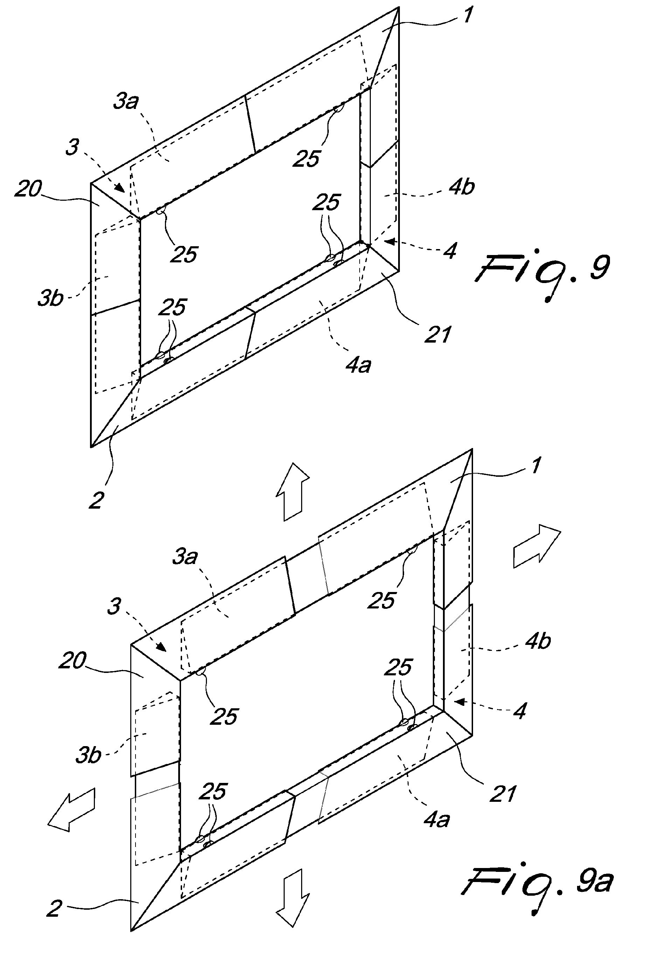

Figures 8, 8a, 9 and 9a illustrate a second embodiment of the panel according to the invention.

In this second embodiment there are a first and a second further L-shaped element 20, 21, adapted to be arranged diagonally opposite.

The first and second angular elements 3, 4 are divided respectively into a first portion 3a, 4a and a second portion 3b, 4b.

The first portion 3a of the first angular element 3 is adapted to couple inside the first L-shaped element and the first further L-shaped element 20 and the second portion 3b of the first angular element 3 is adapted to couple inside the second L-shaped element 2 and to the first further L-shaped element 20.

The first portion 4a of the second angular element 4 is adapted to couple internally to the second L-shaped element 2 and to the second further angular element 21.

The second portion 4b of the second angular element 4 is adapted to couple inside the first L-shaped element 1 and the second further L-shaped element 21.

The first and second portions 3a, 3b and the first and second portions 4a, 4b preferably have a triangular transverse cross-section.

Moreover, the first and second L-shaped elements 1 and 2, as well as the first and second further L-shaped elements 20 and 21, are provided with retention tabs 25 adapted to allow the locking of the panel around a display screen.

It is sufficient to provide, for locking, a pair of tabs 25 for the first and second angular elements 1 and 2 respectively.

Arrangement of the panel according to the invention occurs as follows.

First of all, the user measures the length and height of his own display screen or other parallelepiped product around which he wishes to arrange the panel according to the invention.

Advantageously, one of the two angular elements can provide, printed within the thickness, a ruler that allows to measure the width and height of the display screen.

At this point the user composes the panel with the L-shaped elements 1 and 2 and the respective angular elements 3 and 4, with slightly larger dimensions than those of the display screen around which he/she is to position the panel.

The angular elements 3 and 4 act as telescopic elements that allow to lengthen and widen enlarge the frame thus provided.

Therefore the user arranges the frame around the display screen and then, by acting on the frame sides, closes it so as to adapt it perfectly to the measurements of the screen he/she is interested in.

At this point, the frame thus obtained adheres perfectly to the screen and arranges itself tightly around it, complementing it.

In this manner the user, with a small number of simple moves, is capable of transforming his own display screen, integrating it with a panel that can have advertising or informational purposes.

The arrangement of the panel according to the invention in its second embodiment is substantially similar to what has been described in relation to the first embodiment.

In practice it has been found that the panel according to the present invention fully achieves the intended aim and objects, since it allows to create a frame that is adapted to be arranged around the display screen, with simple moves and in absolutely short times.

The panel thus conceived is susceptible of numerous modifications and variations, all of which are within the scope of the appended claims.

Thus, for example, the panel can be made of cardboard or any other material, and the shape can be the one shown in the drawings or can be more rounded toward the external edges, so as to give a more peculiar appearance.

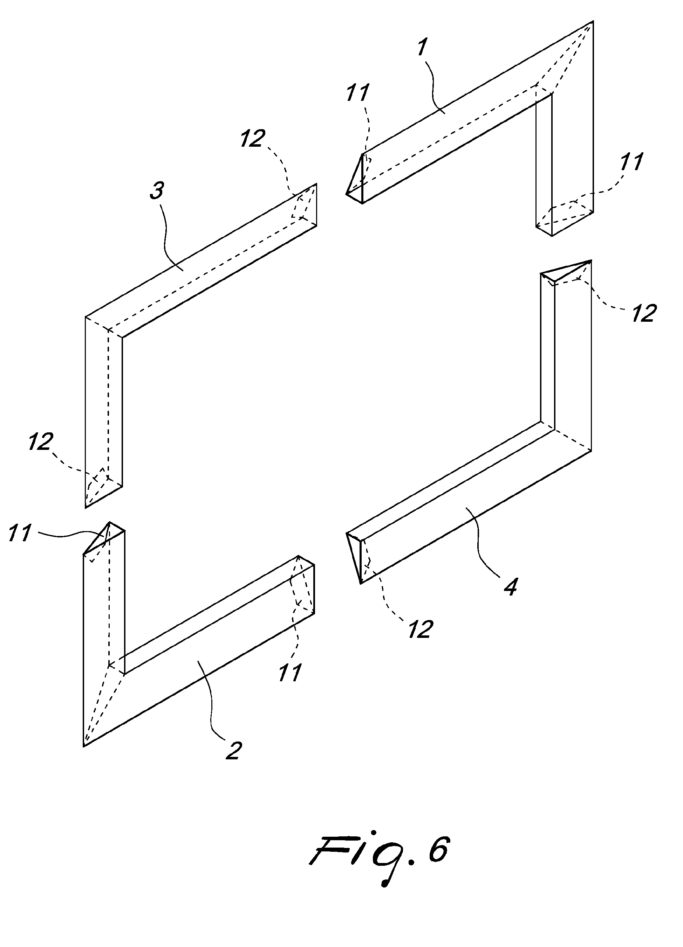

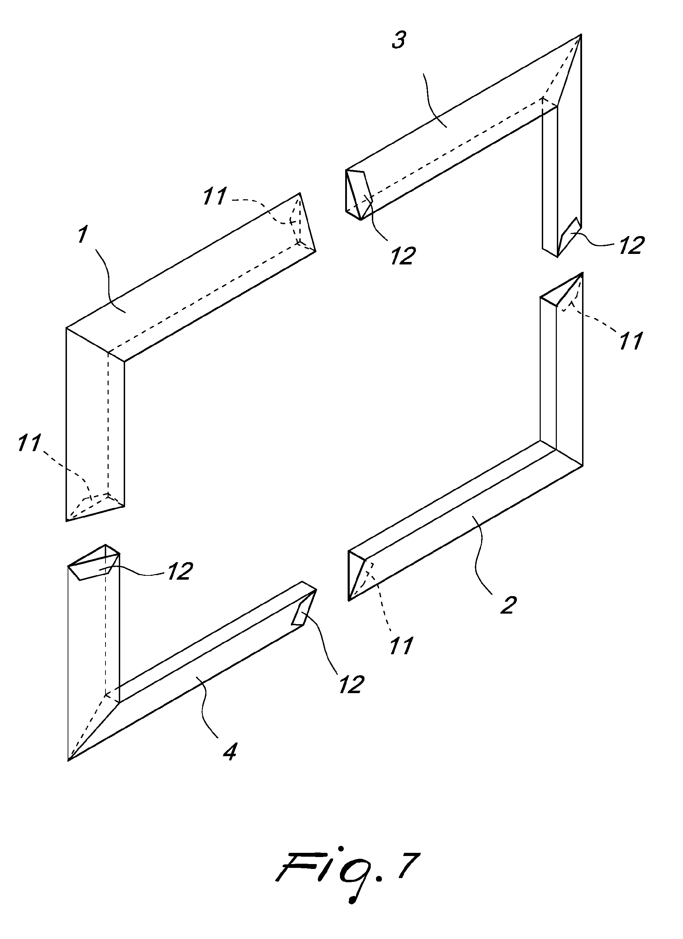

The panel according to the invention, moreover, can have a rectangular transverse cross-section, as shown in the figures, or can have any other cross-section, for example a triangular one, as shown in Figures 6 and 7.

All the details may further be replaced with other technically equivalent elements.

In practice, the materials used, as well as the contingent shapes and dimensions, may be any according to requirements and to the state of the art.

The disclosures in Italian Patent Application no. MI2014A000536, from which this application claims priority, are incorporated herein by reference.

Where technical features mentioned in any claim are followed by reference signs and/or abbreviations, those reference signs and/or abbreviations have been included for the sole purpose of increasing the intelligibility of the claims and accordingly such reference signs and/or abbreviations do not have any limiting effect on the interpretation of each element identified by way of example by such reference signs and/or abbreviations.

## Claims

1. A panel (10) for display screens (5), **characterized in that** it comprises a first L-shaped element and a second L-shaped element (1, 2) and a first angular element and a second angular element (3, 4), said first and second angular elements being adapted to be coupled internally to said first and second L-shaped elements, so as to define telescopically extensible opposite sides of a quadrangular frame adapted to be arranged around a display screen (5).

2. The panel according to claim 1, **characterized in that** said first and second L-shaped elements (1, 2) are tubular contoured elements that are hollow so as to be able to accommodate said angular elements (3, 4).

3. The panel according to claim 1, **characterized in that** said angular elements (3, 4) are L-shaped elements.

4. The panel according to one or more of the preceding claims, **characterized in that** it is made of cardboard, plastics or the like.

5. The panel according to one or more of the preceding claims, **characterized in that** said first and second L-shaped elements have, at each of their ends, at least one tab (12) that is folded inwardly, said first and second angular elements having, at each of their ends, at least one tab (11) that is folded outwardly and is adapted to couple to said at least one tab (12) that is folded inwardly in order to prevent the extraction of said angular elements from said L-shaped elements.

6. The panel according to one or more of the preceding claims, **characterized in that** said first and second L-shaped elements (1, 2) and said first and second angular elements (3, 4) have a triangular transverse cross-section.

7. The panel according to one or more of the preceding claims, **characterized in that** it comprises a first further L-shaped element (20) and a second further L-shaped element (21), which are adapted to be arranged diagonally mutually opposite.

8. The panel according to one or more of the preceding claims, **characterized in that** said first and second angular elements (3, 4) are respectively divided into a first portion (3a, 4a) and a second portion (3b, 4b), said first portion (3a) of said first angular element (3) being adapted to couple internally to said first L-shaped element (1) and to said further L-shaped element (20), said second portion (3b) of said first angular element (3) being adapted to couple internally to said second L-shaped element (2) and to said first further L-shaped element (20), said first portion (4a) of said second angular element (4) being adapted to couple internally to said second L-shaped element (2) and to said second further angular element (21), said second portion (4b) of said second angular element (4) being adapted to couple internally to said first L-shaped element (1) and to said second further L-shaped element (21).

9. The panel according to one or more of the preceding claims, **characterized in that** said first and second portions (3a, 3b) of said first angular element (3) and said first and second portions (4a, 4b) of said second angular element (4) have a triangular transverse cross-section.

10. The panel according to one or more of the preceding claims, **characterized in that** it comprises at least two pairs of tabs arranged at two mutually opposite angular elements (1, 2; 20, 21) or L-shaped elements (3, 4; 3a, 3b; 4a, 4b).
